# EUROPÄISCHE PATENTSCHRIFT

(11) **EP 0 347 737 B1**
(45) Veröffentlichungstag und Bekanntmachung des Hinweises auf die Patenterteilung: **07.09.1994**
(21) Anmeldenummer: 89110808.6
(22) Anmeldetag: 14.06.1989
(51) Int. Cl.: H03L 7/14

(54) **Verfahren zur Synchronisation eines Taktgenerators, insbesondere Taktgenerators einer digitalen Fernsprechvermittlungsstelle**
Synchronisation method for a clock generator, especially of a clock generator of a digital telephone exchange
Méthode de synchronisation de générateurs d'horloge, en particulier de générateurs d'horloge d'une centrale téléphonique numérique

(30) Priorität: 21.06.1988 DE 3820916
(43) Veröffentlichungstag der Anmeldung: 27.12.1989
(73) Patentinhaber: SIEMENS AKTIENGESELLSCHAFT, 80333 München (DE)
(72) Erfinder: Ernst, Wolfram, Dipl.-Ing., D-8000 München 70 (DE); Lindwurm, Franz, Dipl.-Ing., D-8000 München 40 (DE); Troost, Marcel-Abraham, Dipl.-Ing., D-8000 München 71 (DE)

(56) Entgegenhaltungen:
- EP-A- 0 210 124
- DE-A- 2 735 053
- DE-B- 2 735 011
- FR-A- 2 546 691

## Beschreibung

Die Erfindung betrifft ein Verfahren zur Synchronisation eines Taktgenerators, insbesondere Taktgenerators eine digitalen Fernmeldevermittlungsstelle auf einen Referenztakt, der aufgrund seiner Übertragung mit periodischen Phasenschwankungen (Jitter und Wander) behaftet ist, mit Hilfe einer digitalen mikroprozessorgesteuerten Phasenregelschaltung, die die hochfrequenten der periodischen Phasenschwankungen durch Mittelwertbildung über festgelegte Meßzeitspannen eliminiert.

Bei sychronen digitalen Fernmeldevermittlungsnetzen werden die einzelnen Vermittlungsstellen von einer zentralen Normalfrequenzanlage aus synchronisiert, die sich in der höchsten Hierarchiestufe des Netzes befindet. Die zentralen Taktgeneratoren der einzelnen digitalen Vermittlungsstellen werden daher auf eine Referenzfrequenz aufsynchronisiert, die von einem Netzknoten höherer oder gleicher Ordnung gesendet wird, wobei vorgesehen ist, die Referenzfrequenz jeweils auch über einen Ersatzweg im Netz bereitzustellen, auf den bei Störungen automatisch umgeschaltet werden kann.

Die Übertragung der Referenzfrequenzen erfolgt dabei über bestehende Digitalsignalverbindungen zu den betreffenden Vermittlungsstellen, wo sie aus den ankommenden Digitalsignalströmen extrahiert werden. Die Referenzfrequenzen sind demnach mit hochfrequenten und niederfrequenten Phasenschwankungen (Jitter und Wander) behaftet.

Die Phasenregelschaltungen der zentralen Taktgeneratoren in den einzelnen Vermittlungsstellen, die das Aufsynchronisieren auf eine Referenzfrequenz besorgen, sind dabei so geartet, daß sie die hochfrequenten periodischen Phasenschwankungen (Jitter) eliminieren, die niederfrequenten Phasenschwankungen (Wander) dagegen bei der Frequenzregelung des Taktgenerators berücksichtigen, bezüglich der Phasenschwankungen also als Tiefpaß wirken. Die Elimination der hochfrequenten periodischen Phasenschwankungen erfolgt dabei durch Mittelwertbildung über bestimmte Meßzeitspannen.

Bei längerdauernden Unterbrechungen der an eine Vermittlungsstelle gelangenden Referenz wird auf eine andere Referenzfrequenz umgeschaltet, die auf einem oben erwähnten Ersatzweg von einer anderen Vermittlungsstelle her geliefert wird. Sind die Unterbrechungen der Referenzfrequenz nur kurzzeitig, z.B. kürzer als 2 Minuten, dann wird jedoch auf eine Umschaltung verzichtet und die ursprüngliche Referenzfrequenz nach ihrer Wiederkehr weiter zur Synchronisation verwendet. Während der Zeit des Ausfalls der Referenzfrequenz läuft der Taktgenerator frei, was wegen der relativ hohen Stabilität desselben und der vorausgesetzten kurzen Unterbrechungszeit jedoch nicht zu wesentlichen Synchronisationsfehlern führt. Wegen der erwähnten periodischen Phasenschwankungen kann es jedoch beim Wiedereinschalten zu Phasenversätzen kommen, die sich bei Wiederholung einer solchen Wiederanschaltung akkumulieren. Im Zusammenhang mit dem Jitter ist dies dann der Fall, wenn das Wiederauftreten des Referenztaktes zum Zeitpunkt eines Maximums dieser hochfrequenten Phasenschwankung erfolgt, so daß gegenüber dem vor dem Wegfall gültigen Mittelwert ein Phasensprung entsteht. Damit der Wander des Referenztaktes infolge der Unterbrechung und Wiederanschaltung nicht zu einem Synchronisationsfehler führt, muß dafür Sorge getragen werden, daß die im Augenblick der Unterbrechung des Referenztaktes bestehende langzeitige Phasenbeziehung zwischen dem Signal am Ausgang und Eingang des Reglers erhalten bleibt.

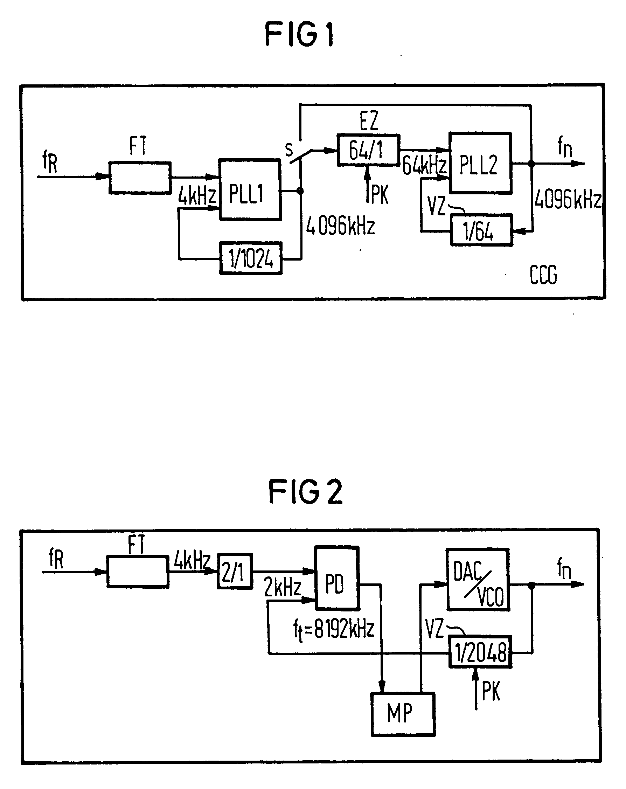

Eine bekannte Schaltungsanordnung, die sowohl dem einen als auch dem anderen Aspekt Rechnung trägt, also für die Aufrechterhaltung der genannten Phasenbeziehung Sorge trägt und ein Einrasten der Regelung auf einem Jitterextremwert verhindert, ist in Figur 1 dargestellt. Dem eigentlichen Regler P112 dieser Anordnung, der die Taktfrequenz fn auf die Referenzfrequenz fR aufsynchronisiert, ist ein zweiter Regler P111 vorgeschaltet, dessen Aufgabe es ist, den hochfrequenten Jitter des Referenztaktes fR auszufiltern. Die Anordnung zeigt ferner eine Reihe von Frequenzteilern, die dazu führen, daß bei einer Ausgangsfrequenz fn von 4096 kHz der Phasenvergleich durch den Regler P111 bei 4 kHz und der Phasenvergleich durch den Regler P112 bei 64 kHz durchgeführt wird. Bei Ausfall des Referenztaktes fR wird der Regler P112 mit Hilfe des Schalters S kurzgeschlossen, so daß sich während der Ausfallzeit die Phasenlage am Reglerausgang nicht ändert.

Mit Hilfe dieser Anordnung ist zwar die Entstehung eines wegen des Wanders des Referenztaktes möglichen Fehlsynchronisierung weitgehend vermieden, beim Rückschalten in den Normalzustand dieser Anordnung entsteht jedoch aufgrund des Jitters ein Rastfehler von hier 1/4096 kHz = 244 ns, der wegen der unterschiedlichen Freilaufeigenschaften der beiden Phasenregelkreise P111 und P112 vorzugsweise in eine Richtung tendiert, bei mehrmaliger Wiederholung der Umschaltvorgänge also zu einer Akkumulation führt. Die Aufgabe der vorliegenden Erfindung besteht nun darin, ein Verfahren zur Synchronisation eines Taktgenerators der eingangs genannten Art dahingehend zu verbessern, daß solche Fehler im Falle des Ausfalls und Wiederauftretens der Referenz weitgehend vermieden werden.

Diese Aufgabe wird mit Hilfe des in Patentanspruch 1 beanspruchten Verfahrens gelöst.

Verfahren zur Synchronisation Taktgeneratoren mit Maßnahmen, um die Frequenzabweichung bei Ausfall und Wiedereinsetzen des Referenztaktes gering zu halten, sind aus DE-A- 2 735 053 und FR-A- 2 546 691 bekannt.

Nachstehend wird die Erfindung anhand eines Ausführungsbeispiels unter Bezugnahme auf eine Zeichnung näher erläutert.

In der Zeichnung zeigen:

Figur 1 die schon erwähnte bekannte Anordnung zur Taktsynchronisation.

Figur 2 eine Anordnung zur Taktsynchronisation, die entsprechend dem erfindungsgemäßen Verfahren arbeitet.

Fig. 3 und 4 Zeitdiagramme zur Veranschaulichung des Rastfehlers bei den Anordnungen gemäß Fig. 1 und 2.

Durch einen Frequenzteiler FT der Anordnung gemäß Figur 2, wird der Referenztakt fR, auf den die von einem spannungsgesteuerten Oszillator VCO abgegebene Taktfrequenz fn synchronisiert werden soll, auf eine Frequenz von 2 kHz heruntergeteilt und dem einen Eingang eines Phasendiskriminatos PD zugeführt. An den anderen Eingang des Phasendiskriminators gelangt die von einer Taktfrequenz von 4096 kHz durch einen weiteren Frequnzuntersetzer VZ auf ebenfalls 2 kHz herunter geteilte Frequenz.

Der erwähnte Phasendiskriminator PD, der spannungsgesteuerte Oszillator VCO mit einem ihm vorgeschalteten Digital/Analog-Wandler DAC und ein Mikroprozessor MP bilden einen Phasenregelkreis PLL, dessen in Durchführung des erfindungsgemäßen Verfahrens erfolgende Arbeitsweise nachstehend näher erläutert wird:

Über einen Regelzyklus von beispielsweise 8,192 Sekunden wird mit Hilfe des Mikroprozessors MP eine Phasenmittelung der durch den Phasendiskriminator PD festgestellten Phasenunterschiede zwischen dem Referenztakt fR und dem Takt fn vorgenommen, um den Jitter des Referenztaktes fR auszufiltern. Der Mittelwert, der sich bei einem solchen Regelzyklus dabei ergibt, wird im störungsfreien Fall über den nachfolgenden Zyklus hinaus im Mikroprozessor MP gespeichert.

Aufgrund der niederfrequenten Phasenschwankungen des Referenztaktes bzw. aufgrund von Phasenunterschieden, die sich dadurch einstellen, daß die vom spannungsgesteuerten Oszillator VCO abgegebene Taktfrequenz fn von der Frequenz des Referenztaktes fR abweicht, ermittelt der Mikroprozessor MP einen Stellwert für den Oszillator VCO, der der aktuellen Phasenbeziehung entspricht.

Fällt nun der Referenztakt aus, so wird der bis dahin aktuelle Stellwert beibehalten, so daß sich der Phasenwert der Taktfrequenz fn nicht verändert. Es bleibt ferner der vorerwähnte gemittelte Phasenwert der letzten abgeschlossenen Meßperiode gespeichert.

Wenn der Referenztakt innerhalb einer vorgegebenen Zeitspanne zurückkehrt, was einen Verzicht auf die Umschaltung auf eine andere Referenzfrequenz rechtfertigt, dann wird der Phasendiskriminator auf Mitte gesetzt und ein Meßzyklus auf T gestartet, der so lang ist, daß die in ihm ermittelte aktuelle Phasenabweichung des Taktes fn vom Referenztakt f_{R} einen genügend kleinen Restfehler entsprechend der Übertragungsfunktion der Mittelwertbildung H = 1/( . T .f . j) aufweist. Der Wert dieser Phasenabweichung wird nun um den Wert der bis zum Wegfall des Referenztaktes ermittelten Phasenabweichung, der, wie angegeben, gespeichert worden war, korrigiert. Dieser korrigierte Wert wird dann dem weiteren Regelprozeß als Offset-Wert zugeordnet.

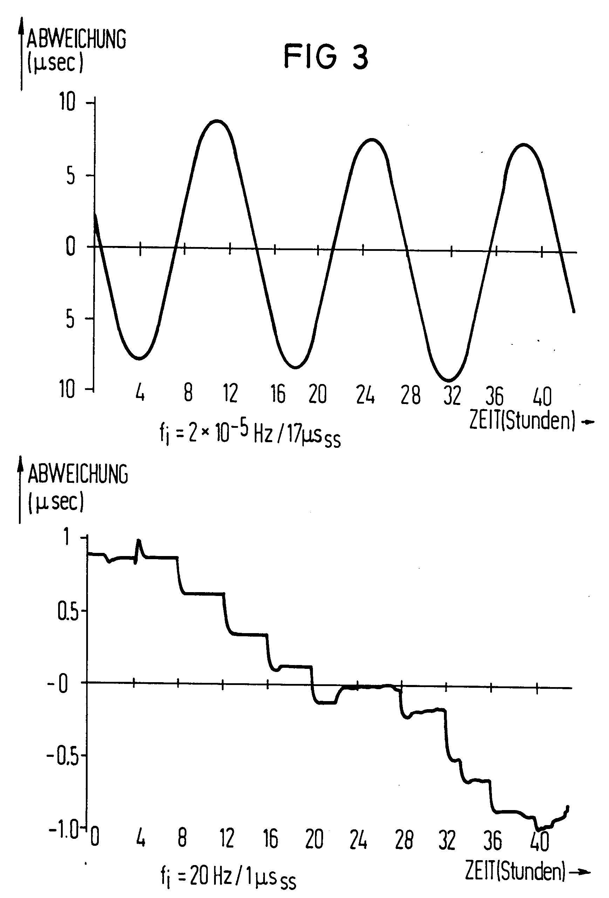

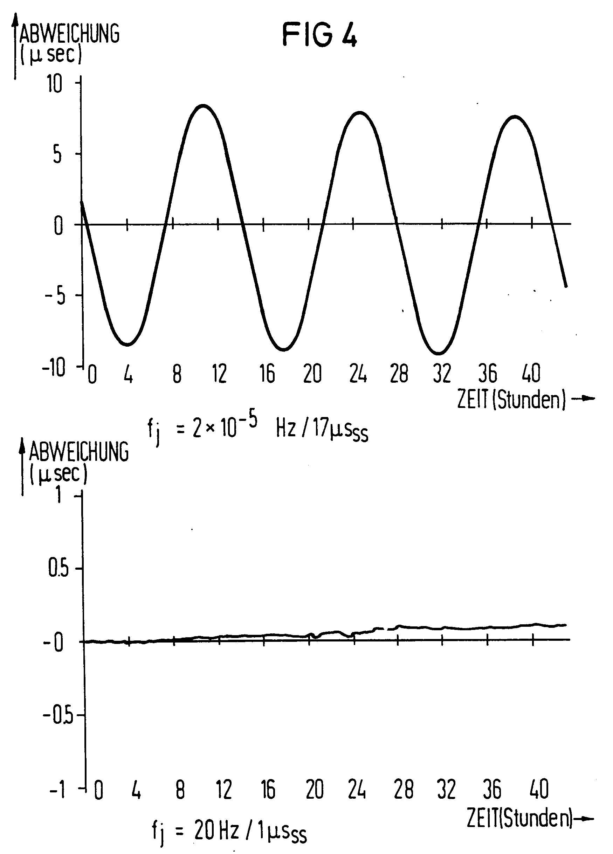

Wie ein Vergleich der Figuren 3 und 4 zeigt, in denen im Falle der Figur 3 die Auswirkungen des erwähnten Rastfehlers über einen Verlauf von ca. 50 Stunden bei Referenztaktunterbrechungen von jeweils 90 s im Abstand von 4 Stunden dargestellt ist und im Falle der Fig. 4 unter den gleichen Voraussetzungen die Verhältnisse bei Anwendung des erfindungsgemäßen Verfahrens mit einem Meßzyklus von 16,3845 dargestellt sind, ergibt sich durch das erfindungsgemäße Verfahren eine ganz beträchtliche Verringerung des akkumulierten Fehlers.

## Patentansprüche

1. Verfahren zur Synchronisation eines Taktgenerators, insbesondere Taktgenerators einer digitalen Fernmeldevermittlungsstelle, auf einen Referenztakt, der aufgrund seiner Übertragung mit periodischen Phasenschwankungen (Jitter und Wander) behaftet ist, mit Hilfe einer digitalen mikroprozessorgesteuerten Phasenregelschaltung, die die hochfrequenten der periodischen Phasenschwankungen durch Mittelwertbildung über festgelegte Meßzeitspannen eliminiert, wobei
a) bei Unterbrechung des Referenztaktes (fR) der spannungsgesteuerte Oszillator (VCO) der Phasenregelschaltung (PLL), dessen Ausgangstakt (fn) den Takt des Taktgenerators bestimmt, mit der bis dahin gültigen Stellwertspannung weiter betrieben wird,
b) bei einer Wiederkehr des Referenztaktes (fR) innerhalb einer vorgegebenen Zeitspanne, wodurch sich ein Umschalten auf einen anderen Referenztakt erübrigt, der Phasendiskriminator auf Mitte gesetzt wird und die aktuelle Phasenabweichung zwischen Referenztakt (fR) und Ausgangstakt (fn) über eine Meßzeitspanne T bestimmt wird, deren Dauer so bemessen ist, daß der durch hochfrequente periodische Phasenschwankungen (Jitter) verursachte Restfehler hinreichend klein ist,
c) der Wert der zum Zeitpunkt der Unterbrechung vorliegenden Phasenabweichung von Referenztakt (fR) und Ausgangstakt (fn) des spannungsgesteuerten Oszillators (VCO), der über die Zwischenzeit hinweg gespeichert worden ist, zur Korrektur der gemäß Merkmal b) ermittelten Phasenabweichung herangezogen wird,
d) der gemäß Merkmal c) erhaltene korrigierte Phasenabweichungswert der wiederaufgenommenen Frequenzregelung als Offset-Wert zugrunde gelegt wird.

## Claims

1. Method for synchronizing a clock generator, preferably a clock generator of a digital telecommunications exchange, with a reference frequency subject to periodic phase fluctuations (jitter and drift) as a result of its transmission, with the aid of a digital microprocessor-controlled phase control circuit that eliminates the high-frequency fluctuations of the periodic phase fluctuations by means of averaging over defined measurement time periods, in which
a) if the reference clock (fR) is interrupted, thevoltage-controlled oscillator (VCO) of the phase control circuit (PLL), the output clock (fn) of which determines the clock of the clock generator, continues to be operated with the control output voltage hitherto valid,
b) if the reference clock (fR) returns within a predetermined time period, which renders a switchover to another reference clock unnecessary, the phase discriminator is set to the middle, and the current phase deviation between reference clock (fR) and output clock (fn) over a measurement time period T is determined, the duration of which is dimensioned such that the residual error caused by high-frequency periodic phase fluctuations (jitter) is sufficiently small,
c) the value of the phase deviation at the time of the interruption from the reference clock (fR) and output clock (fn) of the voltage-controlled oscillator (VCO), which has been stored in the meantime, is used to correct the phase deviation determined in accordance with feature b),
d) the corrected phase deviation value obtained in accordance with feature c) is used as offset value as the basis for the resumed frequency control.

## Revendications

1. Procédé de synchronisation d'un générateur de cadence, notamment d'un générateur de cadence d'un central numérique de télécommunication, sur une cadence de référence, qui est altérée en raison de sa transmission par des fluctuations périodiques de phase (gigue et dérapage), à l'aide d'un circuit à verrouillage de phase numérique et commandé par un microprocesseur, ce circuit éliminant les fluctuations de phase haute fréquence, et ce par moyennage pendant des intervalles de temps de mesure fixés,
a) si la cadence (fR) de référence est interrompue, on fait ensuite fonctionner l'oscillateur (VCO), commandé par tension, du circuit (PLL) à verrouillage de phase, dont la cadence (fn) de sortie détermine la cadence du générateur de cadence, avec la tension de réglage valable jusqu'à cet instant,
b) si la cadence (fR) de référence réapparaît pendant un intervalle de temps prescrit, ce qui rend une commutation sur une autre cadence de référence superflue, on règle le discriminateur de phase à sa valeur de milieu et on détermine le déphasage actuel entre la cadence (fR) de référence et la cadence (fn) de sortie pendant un intervalle (T) de temps de mesure, dont la durée est telle que l'erreur résiduelle provoquée par des fluctuations périodiques haute fréquence (gigue) de phase est suffisamment petite,
c) on utilise la valeur du déphasage présent à l'instant de l'interruption entre la cadence (fR) de référence et la cadence (fn) de sortie de l'oscillateur (VCO) commandé par tension, cette valeur ayant par ailleurs été mémorisée pendant le temps intermédiaire, pour corriger le déphasage déterminé suivant b),
d) la valeur de déphasage corrigée, obtenue suivant c) est prise comme valeur de décalage pour le réglage de la fréquence, qui a repris.
